# EUROPEAN PATENT APPLICATION

(11) **EP 1 486 468 A1**
(43) Date of publication of application: **15.12.2004**
(21) Application number: 02711244.0
(22) Date of filing: 31.01.2002
(51) Int. Cl.: C03C 17/245

(54) **METHOD FOR PRODUCING GLASS PLATE WITH THIN FILM AND GLASS PLATE**

(71) Applicant: Nippon Sheet Glass Company, Limited, Osaka-shi, Osaka 541-8559 (JP)
(72) Inventor: Kiyohara, Koichiro, Osaka-shi, Osaka 541-8559 (JP); Ichiki, Kiyotaka, Osaka-shi, Osaka 541-8559 (JP); Yamamoto, Toru, Osaka-shi, Osaka 541-8559 (JP); Hyodo, Masato, Osaka-shi, Osaka 541-8559 (JP); Hirata, Masahiro, Osaka-shi, Osaka 541-8559 (JP)
(74) Representative: Paget, Hugh Charles Edward
(86) International application number: PCT/JP2002/000747
(87) International publication number: WO 2003/064345

(57) **Abstract**

The present invention provides a method of manufacturing a glass sheet with a thin film. In the method, a coating-film forming gas including a chlorine-containing compound is supplied onto a glass containing an alkali component to generate chloride fine particles containing the alkali component while forming a thin film to allow the chloride fine particles to be included in the thin film or to adhere to the surface thereof, and thereby the surface of the thin film is provided with concavities and convexities. The present invention also provides another method of manufacturing a glass sheet with a thin film. In the another method, a coating-film forming gas including a silicon-containing inorganic compound and an organic gas is supplied onto glass to generate silicon-containing fine particles while forming a silicon-containing film and thereby the silicon-containing fine particles are allowed to adhere to the surface of the silicon-containing film.

## Description

### TECHNICAL FIELD

The present invention relates to a method of manufacturing a glass sheet with a thin film, particularly to a method of manufacturing a glass sheet with a thin film having a surface provided with concavities and convexities. Furthermore, the present invention relates to a glass sheet manufactured by the method.

### BACKGROUND ART

Generally, a thin film to be provided on a glass sheet is formed so as to have a smooth surface. The surface of the thin film, however, intentionally may be provided with concavities and convexities in some cases. For instance, it has been known that when the surface of a hydrophilic thin film is provided with concavities and convexities, the hydrophilic characteristics of the film improve.

In order to provide a surface with concavities and convexities, various methods have been proposed that include the introduction of fine particles, a surface treatment using a treatment solution, etc. In addition, when the thin film to be formed is a crystalline coating film, concavities and convexities are formed at the surface thereof as the crystal grains grow. Accordingly, the control of the growth of crystal grains allows the size and shape of the concavities and convexities to be adjusted to some degree. This method is excellent in requiring no additional raw materials nor additional steps, but there are limitations to the size of formable concavities and convexities and type of formable coating films.

JP62(1987)-44573A discloses a method of providing the surface of a silicon dioxide film with concavities and convexities by allowing silicon dioxide particles generated through a partial reaction of a film forming gas to be included in the silicon dioxide film in forming the silicon dioxide film on a glass sheet by a so-called chemical vapor deposition method (a CVD method). In this method, a silicon-containing gas (monosilane), an oxidizing gas (oxygen), and a separation gas (nitrogen) are supplied from nozzles prepared for the respective gases individually and then monosilane and oxygen react with each other in the space provided above the glass sheet to produce a film and particles of silicon dioxide. The exemplified temperature of the glass sheet is 520°C. The exemplified sum of supply flow rates of the respective gases is 5.7 L/min. In this case, the discharge flow rate is 22 L/min, and the distance between the nozzles and the glass sheet is 2 cm. It is described that under these conditions, silicon dioxide particles with diameters of about 100 nm to 400 nm were generated and a silicon dioxide film having convex portions with radii of about 500 nm and heights of about 300 nm was obtained.

The method described in the above-mentioned reference is excellent in manufacturing efficiency since fine particles are generated from a vapor phase to be included in a thin film and thus it is not necessary to introduce fine particles prepared separately into the thin film. In this method, however, even when a separation gas like nitrogen is supplied together, the reaction between monosilane and oxygen advances locally intensely on the glass sheet surface. Hence, it is difficult to control the size and distribution of the silicon dioxide particles. Thus this method is not suitable particularly for manufacture on a commercial scale in which films having large areas are manufactured. However, the demand for glass sheets (for instance, hydrophilic glass) having a thin film provided with concavities and convexities is ever-growing.

### DISCLOSURE OF THE INVENTION

With the above in mind, the present invention is intended to provide a new method of manufacturing a glass sheet with a thin film. In the method, while a thin film is formed from a coating-film forming gas, fine particles are generated to be included in the thin film, and thereby concavities and convexities are formed using the fine particles.

As the result of assiduous studies made by the present inventors, they found, as a first method, a new method in which fine particles are generated using an alkali component contained in glass to be included in a thin film. That is, the first method of manufacturing a glass sheet with a thin film of the present invention includes supplying a coating-film forming gas that includes a chlorine-containing compound onto a glass sheet or a glass ribbon in a glass sheet manufacturing process to form a thin film on the glass sheet or the glass ribbon, wherein the glass sheet and the glass ribbon contain an alkali component. In the first method, while the thin film is formed, chloride fine particles containing the alkali component are generated to be included inside the thin film or to adhere to the surface of the thin film, and thereby the surface of the thin film is provided with concavities and convexities.

The present inventors also found, as a second method, a method in which fine particles are allowed to be included in a thin film, with the reactivity of a coating-film forming gas that includes a silicon-containing compound being lowered through, for example, the addition of an organic gas or the use of a silicon-containing organic compound. That is, the second method of manufacturing a glass sheet with a thin film of the present invention includes supplying a coating-film forming gas onto a glass sheet or a glass ribbon in a glass sheet manufacturing process to form a thin film on the glass sheet or the glass ribbon. In the second method, while a coating-film forming gas that includes a silicon-containing inorganic compound and an organic gas is supplied to form a silicon-containing film, silicon-containing fine particles are generated to adhere to the surface of the silicon-containing film.

In the second method, since the reactivity of the coating-film forming gas is low, the fine particles tend to be small in diameter. However, the present inventors also found that the silicon-containing fine particles had characteristics that were suitable for crystal growth nuclei. That is, in the above-mentioned second method, a crystalline coating film, in which crystal grains include large ones grown from the silicon-containing fine particles, is formed on the surface of the silicon-containing film to which silicon-containing fine particles have adhered. Thereby the surface of the thin film can be provided with concavities and convexities. In short, when a thin film additionally is formed using silicon-containing fine particles as crystal growth nuclei, sufficiently large concavities and convexities can be obtained.

Furthermore, the following concepts reside in the second method. That is, in the case where a coating-film forming gas is supplied onto a glass sheet or a glass ribbon to react to form fine particles, the gas is made to react gradually and the conditions for supply and exhaust of the gas are adjusted suitably, which allows the fine particles to adhere more evenly to the surface of a thin film to be formed on the glass surface. In other words, fine particles are generated gradually throughout a course from a part for supplying the coating-film forming gas to a part for exhausting it in a coating-film formation apparatus and are allowed to fall continuously on the glass sheet or glass ribbon, which allows the fine particles to be disposed more evenly on the surface of the thin film. Further, when a crystalline thin film additionally is formed on the fine particles disposed evenly as described above, the fine particles serve as nuclei to grow crystals. Thereby uniform and large concavities and convexities are formed at the surface.

### BRIEF DESCRIPTION OF DRAWINGS

FIG. 1 is a cross-sectional view showing one embodiment of the glass sheet with a thin film that is manufactured by the method according to the present invention.
FIG. 2 is a cross-sectional view showing another embodiment of the glass sheet with a thin film that is manufactured by the method according to the present invention.
FIG. 3 is a diagram showing the configuration of an example of the apparatus that is used in the methods of the present invention.
FIG. 4 is a cross-sectional view showing an example of the coater that is used in the methods of the present invention.
FIG. 5 is a photograph showing the state of a glass sheet with a thin film manufactured according to an example that was observed with a scanning electron microscope.
FIG. 6 is a photograph showing the state of a glass sheet with a thin film manufactured according to another example that was observed with a scanning electron microscope.

### BEST MODE FOR CARRYING OUT THE INVENTION

Hereinafter, preferred embodiments of the present invention will be described.

First, the first method is described. In this method, it is preferable that the glass to serve as a substrate is maintained at a temperature that allows fine particles of alkali metal chloride to be generated from an alkali component (alkali metal such as sodium, potassium, etc.) contained in the glass and chlorine contained in the coating-film forming gas. The suitable temperature is 600°C or higher, for example, 600°C to 720°C.

At least one chlorine-containing compound is used in the coating-film forming gas. The chlorine-containing compound may be selected suitably according to the type of the film to be formed. For example, when a tin oxide film is to be formed, the chlorine-containing compound can be tin tetrachloride, monobutyltin trichloride, dimethyltin dichloride, dibutyltin dichloride, or dioctyltin dichloride. Among these compounds, organic tin compounds (organic tin chlorides), particularly monobutyltin trichloride and dimethyltin dichloride are suitable. Furthermore, when a titanium oxide film is to be formed, for example, titanium tetrachloride can be used. Moreover, when a zinc oxide film is to be formed, for example, zinc dichloride can be used. Further, when a film of indium oxide doped with tin (ITO) is to be formed, dimethylindium chloride or the like can be used.

Generally, besides a chlorine-containing compound, a reactive gas such as an oxidizing gas is added to the coating-film forming gas. The oxidizing gas can be oxygen, water vapor, dry air, carbon dioxide, carbon monoxide, nitrogen dioxide, or ozone. Other gases may be added to the coating-film forming gas to adjust the characteristics (for example, electrical characteristics) of the coating film.

The thin film to which chloride fine particles have adhered also can be used with the fine particles being exposed on the surface and the fine particles themselves forming convex portions. However, since the chloride (typified by sodium chloride) has water solubility in general, it is preferable that a film for covering the fine particles additionally is formed to prevent the chloride from eluting. Specifically, the thin film including chloride fine particles may be formed as a first thin film, and then a second thin film for covering chloride fine particles may be formed on the first thin film. Furthermore, additional thin films may be stacked on the second thin film.

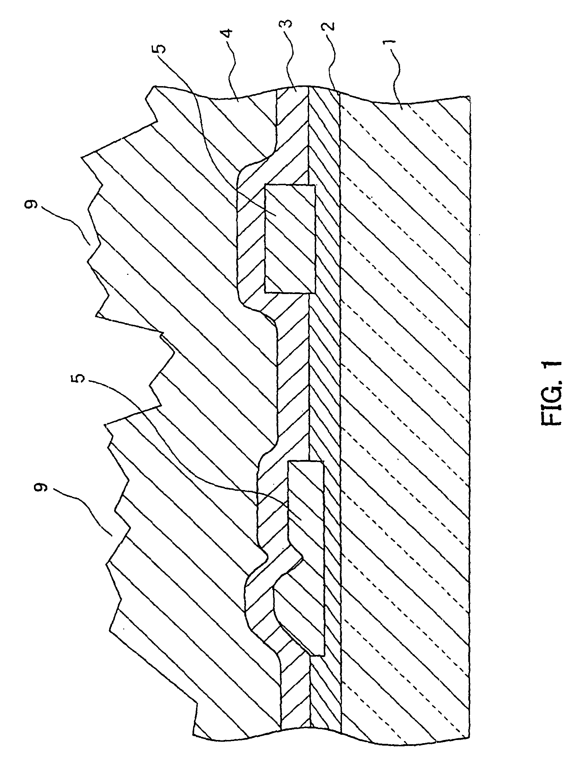

FIG. 1 is a cross-sectional view of an example of the glass sheet with a thin film manufactured by the first method. A tin oxide film 2 is formed as a first thin film on a glass sheet 1 containing an alkali component. Chloride fine particles 5 generated in forming the tin oxide film by the CVD method have adhered to the surface of the tin oxide film, with their bottom parts being located below the surface of the film 2. Such a state suggests that the fine particles have adhered thereto during the formation of the film carried out by the CVD method. However, all the fine particles generated by using the first method are not necessarily included in the state shown in the drawing. As long as the surface is provided with concavities and convexities, the chloride fine particles may be included inside the film 2.

In the type shown in the drawing, a second thin film (a silicon oxide film 3) and a third thin film (a tin oxide film 4 doped with fluorine (hereinafter referred to as a "SnO₂:F film")) also are formed on the tin oxide film 2. Convex portions 9 that reflect the shape and size of the fine particles 5 are formed on the surfaces of the films 3 and 4.

Suitable diameters and heights of the chloride fine particles are about 100 nm to 500 nm and 50 nm to 200 nm, respectively. In addition, a suitable distribution density of the chloride fine particles (in other words, a distribution density of the convex portions) is about 100 to 1000 pieces per 100 µm² of the glass surface. The size and distribution density of the chloride fine particles can be adjusted through control of the composition ratio and amount of a film forming gas to be supplied, glass temperature, etc. The chloride fine particles often take shapes reflecting the rock-salt crystal structure as shown in the drawing as far as the present inventors confirmed.

In the CVD method, generally, film formation is carried out while the amount of gas to be supplied and the amount of gas to be exhausted are adjusted within a suitable range in a coater. Generally, the amount of gas to be exhausted is set to be higher than the amount of gas to be supplied to a degree that can prevent impurities from being introduced into the film. In this case, however, the balance between the amount of gas to be supplied and the amount of gas to be exhausted is adjusted so that the chloride fine particles are included in the film or adhere to the film surface. The behavior of the fine particles generated from a vapor phase also is affected considerably by the size of the space provided above the glass, specifically, the height from the glass surface to the lower end of the coater. Hence, it is advantageous that when a film is formed by the CVD method, the height of the space (hereinafter referred to simply as "height of coater") and the ratio of an amount of gas to be exhausted to an amount of gas to be supplied (the amount of gas to be exhausted/the amount of gas to be supplied; hereinafter referred to as a "exhaust bias") are controlled within suitable ranges for allowing the fine particles to be included in or to adhere to the film.

The ranges also depend on the type of the film, selected raw materials, film formation temperature, etc. Generally, however, it is preferable that the exhaust bias is in the range of 1.0 to 1.5 or 3.0 to 5.0 while the height of coater is in the range of 8 mm to 10 mm. When the exhaust bias is in the range of 1.0 to 1.5, the air flow below the lower face of the coater is calm and therefore formed chloride fine particles are not stirred up by the air flow. On the other hand, when the exhaust bias is in the range of 3.0 to 5.0, the chloride fine particles are stirred up by the air flow once, but a turbulent flow occurs near exhaust ports of the coater and thereby the chloride fine particles fall again near the exhaust ports onto the glass sheet. Accordingly, even when the exhaust bias is in the range of 3.0 to 5.0, the chloride fine particles can adhere to the thin film surface.

Next, the second method is described. In this method, since the reaction with the glass component is not essential, the glass temperature may be in the range of about 500°C to 700°C. In this method, fine particles of a silicon compound (typified by silicon oxide) are generated from a vapor phase while the reaction of a film forming gas that is supplied after being prepared by mixing raw material gases together is controlled through the addition of an organic gas or the use of a silicon-containing organic compound.

Examples of the silicon-containing inorganic compound include monosilane, disilane, trisilane, and monochlorosilane. A coating-film forming gas containing a silicon-containing organic compound may be used instead of the coating-film forming gas containing a silicon-containing inorganic compound and an organic gas. In this case, examples of the silicon-containing organic compound include 1,2-dimethylsilane, 1,1,2-trimethyldisilane, 1,1,2,2-tetramethyl disilane, tetramethyl orthosilicate, and tetraethyl orthosilicate (TEOS).

An organic compound having a carbon-carbon unsaturated bond, for instance ethylene or acetylene is suitable as the organic gas. The silicon-containing inorganic compound that is typified by monosilane (SiH₄) has high reactivity, but a double bond and a triple bond formed between carbons have an effect of inhibiting the reactivity. Preferably, the organic gas is added so that the carbon-carbon unsaturated bond per silicon atom is 5 to 7 in the film forming gas in terms of mole ratio.

In the second method, similarly a reactive gas such as, for example, an oxidizing gas, also is added to the coating-film forming gas. The gases described above as examples may be used for the oxidizing gas. Other gases may be added to adjust the characteristics of the coating film as in the above.

Fine particles generated by this method serve as crystal growth nuclei having high selectivity although the detailed reason is not clear at a present stage. Hence, when a crystalline coating film additionally is formed on the silicon oxide film with the fine particles that have adhered to its surface, part of crystal grains grow larger. Such high selectivity cannot be obtained from, for example, the chloride fine particles generated by the first method.

Specifically, for example, a tin oxide film, a zinc oxide film, a titanium oxide film, or an ITO film can be used as the crystalline coating film. In this connection, the crystalline coating film is not limited in type, component, or the like as long as crystal grains grow using fine particles as growth nuclei. The crystalline film may contain additives like, for instance, fluorine or antimony with which a tin oxide film is doped in order to improve its conductivity.

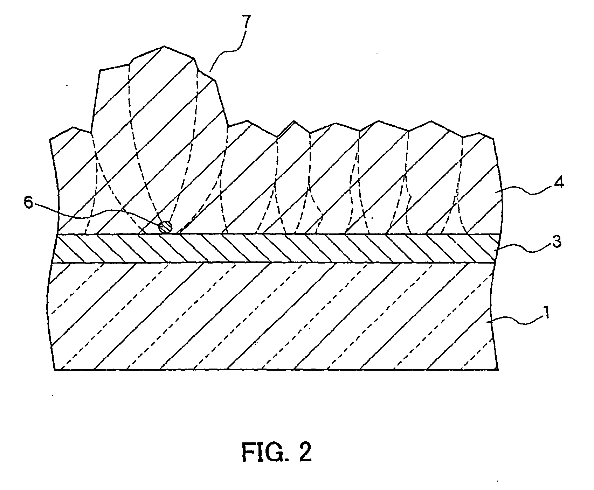

FIG. 2 is a cross-sectional view of an example of the glass sheet with a thin film manufactured by the second method. A silicon oxide film 3 is formed as a first thin film on a glass sheet 1. A silicon oxide fine particle 6 generated while the silicon oxide film is formed by the CVD method has adhered to the surface of the silicon oxide film. Part of the fine particle may be embedded in the silicon oxide film, which is not shown in the drawing.

The silicon oxide fine particle 6 tends to be smaller in diameter due to the addition of the organic gas (or the use of the silicon-containing organic compound) as compared to the case where the organic gas is not added. As shown in the drawing, however, when a tin oxide film 4 that is a crystalline coating film is formed as a second thin film on the silicon oxide film, the fine particle 5 serves as a growth nucleus and thereby part of tin oxide crystals grows abnormally. Thus, a relatively large convex portion 7 is formed above the fine particle and thereby concavities and convexities appear that are far larger in size than the fine particle itself. As shown in the drawing, the convex portion 7 has a dome-shaped appearance in general.

Since there is a large difference in diameter between the silicon oxide fine particle and the convex portion formed thereabove, when the cross-section of the convex portion is observed after the crystalline coating film is formed, the fine particle is not always observed below the convex portion in the cross-section (i.e. the cross-section is not always the one including the fine particle). The distribution and size of fine particles can be checked through observation (observation carried out with, for instance, a scanning electron microscope (SEM)) of the silicon oxide film surface before the crystalline coating film is formed. It has been confirmed experimentally through the observations of the film surface carried out before and after the crystalline coating film is formed that there is a strong correlation between the generation of the fine particles on the silicon oxide film surface and the generation of the convex portions on the crystalline coating film surface. According to the SEM observation in this experiment, the silicon oxide fine particles that are particularly suitable as nuclei to be used for forming the dome-shaped convex portions like those shown in the drawing had diameters of not larger than 100 nm, for example, about 5 nm to 40 nm.

The size and distribution density of the convex portions can be adjusted through the control of, for example, the thickness of the crystalline coating film, a component ratio of a gas to be used for forming the silicon oxide film, or an amount of the gas to be supplied.

In the second method, similarly it is advantageous that when the film is formed by the CVD method, the exhaust bias and the height of coater are controlled within suitable ranges for allowing fine particles to be included in the film. The ranges also depend on the selected materials, film formation temperature, film formation method (i.e. on-line film formation or off-line film formation), etc. In the case of the on-line film formation, however, a preferable exhaust bias is 1.0 to 1.5 or 3.0 to 5.0 in general. In this connection, the "on-line film formation" denotes a method of forming the above-mentioned thin films successively on a glass ribbon in a float glass manufacturing process. On the other hand, the "off-line film formation" indicates a method of subjecting individual glass sheets to a thin film formation process using a film formation apparatus, wherein the glass sheets are obtained by forming glass into a sheet first and then cutting the glass into glass sheets with a suitable size. When the exhaust bias is in the range of 1.0 to 1.5, since no turbulent flow occurs below the lower face of the coater, fine particles formed in a gas layer fall continuously to be disposed evenly on the glass surface. When the exhaust bias is in the range of 3.0 to 5.0, the fine particles fall on the glass sheet surface due to the turbulent flow that occurs near the exhaust ports of the coater as described above. On the other hand, in the case of the off-line film formation, a preferable exhaust bias is 1.0 to 2.0 or 3.5 to 6.0 for the same reasons as those described above. A preferable height of coater is 8 mm to 12 mm in the case of the on-line film formation while it is 15 mm to 25 mm in the case of the off-line film formation.

A method of forming a film (on-line film formation) on the top surface (the surface that is not in contact with tin in a tin bath) of a glass ribbon by using heat of the glass ribbon in a float glass manufacturing process is described below as a particularly preferable embodiment of the present invention.

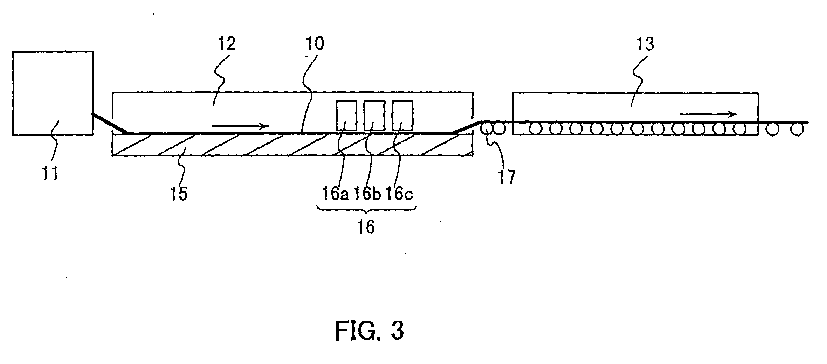

FIG. 3 shows one type of the apparatus for forming a thin film on a glass ribbon surface by the CVD method in the float glass process. As shown in FIG. 3, in this apparatus, a predetermined number of coaters 16 (three coaters 16a, 16b, and 16c in the type shown in the drawing) are disposed directly above a glass ribbon 10. The glass ribbon 10 is formed from molten glass, which is poured from a melting furnace 11 into a float bath 12 to be formed into a belt-like form on a tin bath 15 while moving thereon. The number and arrangement of the coaters may be selected suitably depending on the type and thickness of the coating films to be formed. These coaters supply materials, which have been prepared and evaporated, to form coating films on the top surface of the glass ribbon 10 successively. By supplying different materials from the respective coaters, a first thin Film, a second thin film, and a third thin film can be stacked successively. The temperature of the glass ribbon 10 can be controlled by a heater and a cooler (not shown in the drawing) installed inside the float bath 12 so that the glass ribbon 10 has a predetermined temperature directly before reaching the coaters 16. The glass ribbon 10 with the thin films thus formed is lifted by a roller 17 and then is annealed in an annealing furnace 13.

In this type, it is possible to obtain high glass temperature, specifically 600°C to 750°C, and particularly about 630°C to 750°C. The temperature of the glass ribbon 10 may be measured with a radiation thermometer to be controlled.

The application of the present invention is not limited to the on-line film formation. The present invention also can be carried out by the off-line film formation.

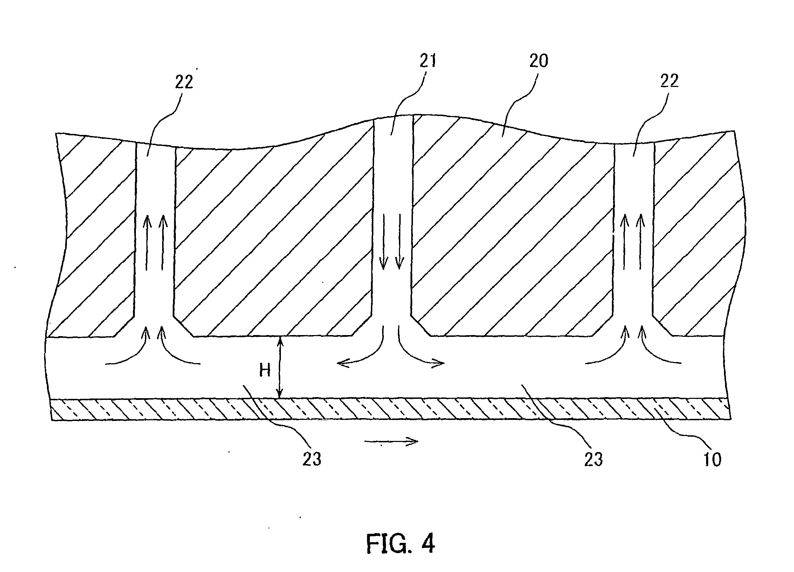

FIG. 4 shows an example of the coater that can be used for carrying out the present invention. This coater 20 is disposed so that its lower end is spaced from the surface of the glass ribbon 10 by a distance (height) *H*. A film forming gas is supplied from a supply nozzle 21 into a space 23 provided between the coater and the glass surface. Reactions such as pyrolysis and oxidation of the film forming gas that take place in the space allow a predetermined film to be formed on the glass ribbon 10. The gas that has been used for the film formation is exhausted from exhaust nozzles 22 disposed so as to sandwich the supply nozzle therebetween in the direction in which the glass ribbon is conveyed (in the direction indicated with an arrow in the drawing). It is not necessary to provide this coater with nozzles that are used for separating the components of the film forming gas to be supplied. It is enough for the coater to be provided with a single supply nozzle.

A glass sheet with a thin film having concavities and convexities obtained as described above can be applied in various uses by utilizing the concavities and convexities. The intended use of this glass sheet with a thin film is not particularly limited but it is particularly suitable to be used as a hydrophilic glass.

### Examples

Hereinafter, the present invention is described further in detail using examples but is not limited to the following examples.

### Formation of Concavities and Convexities using Chloride Fine Particles

In Examples 1 and 2 as well as Comparative Examples 1 and 2, thin films were stacked on a glass ribbon surface by the CVD method using the same apparatus as that described with reference to FIGs. 3 and 4. During the film formation, a mixed gas consisting of 98 vol.% of nitrogen and 2 vol.% of hydrogen was supplied into the float bath and thereby the space inside the float bath was maintained at a slightly higher pressure than that outside the bath. A soda-lime glass material that had been melted in a melting furnace was poured into the float bath and was formed into a glass ribbon with a thickness of 4 mm. Specific film formation methods are described below.

### Example 1

A film forming gas consisting of dimethyltin dichloride (DMT), oxygen, and nitrogen was supplied from a coater located on the furthest upstream side at a rate of 500 L/min, with the glass ribbon having a surface temperature of 680°C directly before reaching the coater. With respect to this coater, the exhaust bias was set at 1.2 while the height of coater was set at 8 mm. Thus, a tin oxide film with a thickness of about 23 nm was formed on the top surface of the glass ribbon.

Subsequently, a mixed gas consisting of monosilane, ethylene, and oxygen was supplied from a coater located downstream. The exhaust bias and the height of coater of this coater were set in the ranges that had been used conventionally and were controlled so that even if fine particles of silicon oxide were generated, the film was prevented from including them. Then, a mixed gas consisting of dimethyltin dichloride, oxygen, water vapor, nitrogen, and hydrogen fluoride was supplied from a coater located further downstream. Thus, a silicon oxide film with a thickness of about 25 nm and a SnO₂:F film with a thickness of about 320 nm were stacked sequentially on the tin oxide film. This glass ribbon was cut on a further downstream side and thereby a glass sheet with a thin film was obtained.

### Comparative Example 1a

A glass sheet with a thin film was obtained in the same manner as in Example 1 except that the glass temperature was set at 580°C when the tin oxide film was formed on the surface of the glass ribbon.

### Comparative Example 1b

A glass sheet with a thin film was obtained in the same manner as in Example 1 except that the exhaust bias was set at 2.0 when the tin oxide film was formed on the surface of the glass ribbon.

### Example 2

A glass sheet with a thin film was obtained in the same manner as in Example 1 except that the thickness of the SnO₂:F film was set at about 600 nm.

### Comparative Example 2

A glass sheet with a thin film was obtained in the same manner as in Example 2 except that the exhaust bias was set at 2.0 when the tin oxide film was formed on the surface of the glass ribbon.

Haze ratios of the glass sheets with a thin film obtained in the above were measured. In this case, the haze ratios were measured according to the haze value measurement method described in Japanese Industrial Standards (JIS) K7105-1981. The results are shown in Table 1.

**Table 1**

| (%) | |
|---|---|
| | Haze Ratio |
| Example 1 | 1.2 |
| Comparative Example 1a | 0.7 |
| Comparative Example 1b | 0.7 |
| Example 2 | 8.8 |
| Comparative Example 2 | 5.2 |

The haze ratio is convenient for a comparison of states of the film surfaces since it reflects the size of concavities and convexities provided for the film surface. The increase in thickness of the tin oxide film that is a crystalline coating film causes the increase in size of crystal grains and thus increases the haze ratio. As shown in Table 1, however, there were considerable differences in haze ratio between the examples and the comparative examples even when the tin oxide films formed in the examples and the comparative examples had the same thickness. The surfaces of the thin films (SnO₂:F films) were observed with the SEM. As a result, it was found that large convex portions existed scatteredly on the film surface in Examples 1 and 2 while being not observed in the comparative examples.

The glass sheets each were broken so that a portion thereof included the convex portions and then the cross-section of the portion was observed with the SEM. As a result, it was confirmed that crystal grains were included in the film and were located below the convex portions. It was confirmed that the crystal grains consisted almost entirely of sodium chloride.

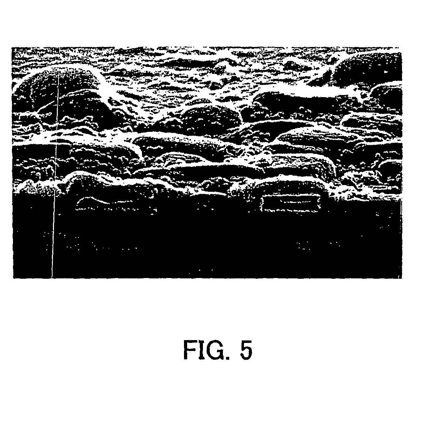

With respect to a glass sheet with a thin film (with the SnO₂:F film having not been formed thereon yet) with a tin oxide film and a silicon oxide film being formed in the same manner as in Example 1, the states of its cross-section and surface were observed with the SEM. The SEM picture thereof is shown in FIG. 5. When being shown schematically, this cross-section has a configuration like the one shown in FIG. 1.

Conceivably, in Comparative Example 1a, the glass temperature was too low to generate chloride fine particles from the chlorine-containing compound used therein, while in Comparative Examples 1b and 2, the chloride fine particles were discharged out of the system swiftly.

### Formation of Concavities and Convexities using Silicon-containing Fine Particles

In Example 3 and Comparative Example 3, similarly films were formed on a glass ribbon in the same manner as in the above. In Example 4 and Comparative Example 4, films were formed on a glass sheet. Specific film formation methods are described below.

### Example 3

A film forming gas consisting of dimethyltin dichloride (DMT), oxygen, and nitrogen was supplied from a coater located on the furthest upstream side, with the glass ribbon having a surface temperature of 650°C directly before reaching the coater. Thus, a tin oxide film with a thickness of about 23 nm was formed on the top surface of the glass ribbon. The exhaust bias and height of coater of the coater were set in the ranges that had been employed conventionally and were controlled to prevent chloride fine particles generated thereby from being included in the film.

Subsequently, a film forming gas consisting of monosilane, ethylene, and oxygen was supplied from a coater located downstream. With respect to this coater, the exhaust bias was set at 1.2 while the height of coater was set at 12 mm. The mole ratio of ethylene to monosilane of the film forming gas was set at 6. Thus, a silicon oxide film with a thickness of about 25 nm was formed on the tin oxide film.

Then, a mixed gas was supplied from a coater located further downstream to form a SnO₂:F film with a thickness of about 600 nm in the same manner as in Example 1. This glass ribbon was cut on a further downstream side and thereby a glass sheet with a thin film was obtained.

### Comparative Example 3

A glass sheet with a thin film was obtained in the same manner as in Example 3 except that the exhaust bias was set at 2.4 and the height of coater was set at 6 mm when the silicon oxide film was formed.

### Example 4

A glass substrate with thin films was produced by off-line film formation. A 3-mm thick glass sheet that had been precut to have a size of 150 mm x 150 mm was placed in a belt furnace and was conveyed below a coater while a film forming gas consisting of monosilane, ethylene, and oxygen was supplied from the coater. The coater used herein had the same configuration as that shown in FIG. 4. The exhaust bias and height of coater of the coater were 1.5 and 25 mm, respectively. The mole ratio of ethylene to monosilane of the film forming gas was set at 6. Thus, a silicon oxide film with a thickness of about 30 nm was formed on the surface of the glass sheet.

Subsequently, while the glass sheet was conveyed below another coater installed in the belt furnace, a mixed gas consisting of dimethyltin dichloride, oxygen, water vapor, nitrogen, and hydrogen fluoride was supplied from the coater onto the tin oxide film. Thus, a glass sheet with a thin film was obtained with a SnO₂:F film whose thickness was about 600 nm being formed on the silicon oxide film. The temperature of the glass sheet was set at about 600°C in forming both the films described above.

### Comparative Example 4

A glass sheet with a thin film was obtained in the same manner as in Example 4 except that the exhaust bias was set at 3.1 and the height of coater was set at 13 mm when the silicon oxide film was formed.

The haze ratios of the respective glass sheets with a thin film thus obtained were determined in the same manner as in the above. The results are shown in Table 2.

**Table 2**

| (%) | |
|---|---|
| | Haze Ratio |
| Example 3 | 8.1 |
| Comparative Example 3 | 4.4 |
| Example 4 | 8.6 |
| Comparative Example 4 | 2.0 |

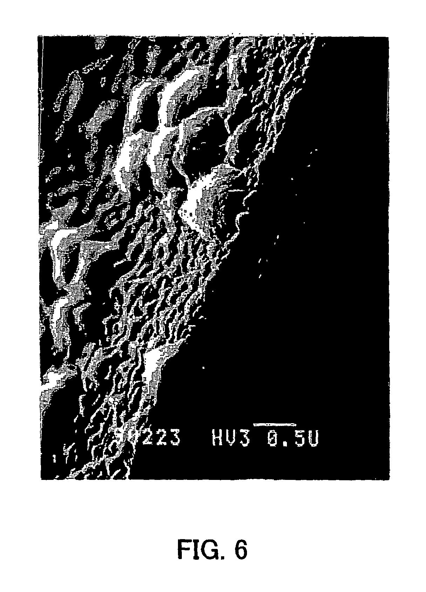

As indicated in Table 2, there were considerable differences in haze ratio between the examples and the comparative examples. The surfaces of the thin films (tin oxide films doped with fluorine) were observed with the SEM. As a result, it was found that large dome-shaped convex portions existed scatteredly on the film surfaces in Examples 3 and 4 while being not observed in the comparative examples. The SEM picture of the surface of the thin film formed according to Example 4 was shown in FIG. 6. The glass sheet was broken so that a portion thereof included the convex portions and then the cross-section of the portion was observed with a transmission electron microscope (TEM). As indicated schematically with the broken lines in FIG. 2, it was confirmed that crystal grains of tin oxide located below the convex portions had grown to partly have an abnormally large size.

Furthermore, a glass sheet with a thin film having a silicon oxide film alone was produced in the same manner as in Example 4. The surface of this film was observed with the SEM. It was confirmed that fine particles with diameters of about 5 nm to 40 nm were present scatteredly. The fine particles were silicon oxide fine particles. On the other hand, such fine particles were not present on the surface of a silicon oxide film formed in the same manner as in Comparative Example 4. In Comparative Example 4 as well as Comparative Example 3, conceivably, the fine particles generated therein were exhausted out of the system swiftly.

As described above, the glass sheet with a thin film manufactured by the method of the present invention is characterized in that chloride fine particles or silicon-containing fine particles are included in the film. Conceivably, the type (for example, FIG. 1) in which chloride fine particles are included in the film (without being in contact with the glass sheet) or adhere to the film surface and the chloride fine particles allow convex portions to be formed on the film surface, and the type (for example, FIG. 2) in which dome-shaped convex portions are formed due to the partial growth of crystal grains on the surface of a crystalline coating film grown from a silicon oxide film (with a substantially flat surface) were examples of the configurations that were achieved by the methods of the present invention for the first time.

According to the present invention, as a film is formed by the CVD method, fine particles are generated to be included in the thin film, and thereby a glass sheet with a thin film having a surface provided with concavities and convexities can be manufactured efficiently. The method of the present invention involves no rapid reaction that occurs in the film forming gas, and therefore also is suitable for manufacture on a commercial scale.

## Claims

1. A method of manufacturing a glass sheet with a thin film, comprising supplying a coating-film forming gas including a chlorine-containing compound onto a glass sheet or a glass ribbon in a glass sheet manufacturing process to form a thin film on the glass sheet or the glass ribbon, the glass sheet and the glass ribbon containing an alkali component,
wherein while the thin film is formed, chloride fine particles containing the alkali component are generated to be included inside the thin film or to adhere to a surface of the thin film, and thereby the surface of the thin film is provided with concavities and convexities.

2. The method of manufacturing a glass sheet with a thin film according to claim 1, wherein the thin film is formed on the glass sheet or the glass ribbon having a temperature of at least 600°C.

3. The method of manufacturing a glass sheet with a thin film according to claim 1, wherein a thin film having convex portions is formed as a first thin film, and a second thin film that covers the chloride fine particles is formed on the first thin film.

4. The method of manufacturing a glass sheet with a thin film according to claim 1, wherein a coater is disposed that supplies the coating-film forming gas onto the glass sheet or the glass ribbon and then exhausts the gas, a ratio in amount of a gas to be exhausted to a gas to be supplied in the coater is set in a range of 1 to 1.5 or 3.0 to 5.0, and a height as measured from the surface of the glass sheet or the glass ribbon to the coater is set in a range of 8 mm to 10 mm.

5. A method of manufacturing a glass sheet with a thin film, comprising supplying a coating-film forming gas onto a glass sheet or a glass ribbon in a glass sheet manufacturing process to form a thin film on the glass sheet or the glass ribbon,
wherein while a coating-film forming gas including a silicon-containing inorganic compound and an organic gas is supplied to form a silicon-containing film, silicon-containing fine particles are generated to adhere to a surface of the silicon-containing film.

6. The method of manufacturing a glass sheet with a thin film according to claim 5, wherein a crystalline coating film in which crystal grains include large ones grown from the silicon-containing fine particles is formed on the surface of the silicon-containing film to which the silicon-containing fine particles have adhered, and thereby the surface of the thin film is provided with concavities and convexities.

7. The method of manufacturing a glass sheet with a thin film according to claim 5, wherein the organic gas is an organic compound having a carbon-carbon unsaturated bond.

8. The method of manufacturing a glass sheet with a thin film according to claim 5, wherein a coater is disposed that supplies the coating-film forming gas onto the glass ribbon and then exhausts the gas, a ratio in amount of a gas to be exhausted to a gas to be supplied in the coater is set in a range of 1 to 1.5 or 3.0 to 5.0, and a height as measured from the surface of the glass ribbon to the coater is set in a range of 8 mm to 12 mm.

9. A method of manufacturing a glass sheet with a thin film, comprising forming a thin film from a coating-film forming gas on a glass sheet or a glass ribbon in a glass sheet manufacturing process,
wherein fine particles are generated by allowing the coating-film forming gas to react gradually in a course from a part for supplying the coating-film forming gas to a part for exhausting the gas in a coating-film formation apparatus, and the fine particles are adhered to a surface of the thin film.

10. A glass sheet with a thin film manufactured by a method according to claim 1, 5, or 9.
